(19) **Europäisches Patentamt**

**European Patent Office**

**Office européen des brevets**

(11) **EP 1 239 509 A1**

(12) **EUROPEAN PATENT APPLICATION**

(43) Date of publication:
**11.09.2002 Bulletin 2002/37**

(51) Int Cl.⁷: **H01J 37/141**, H01J 37/18, H01J 37/301

(21) Application number: **02004970.6**

(22) Date of filing: **05.03.2002**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI** | (71) Applicant: **Nikon Corporation**<br>**Tokyo (JP)** |
| (30) Priority: **05.03.2001 US 797955** | (72) Inventor: **Sogard, Michael**<br>**Menlo Park, California 94025 (US)** |
| | (74) Representative: **Viering, Jentschura & Partner**<br>**Postfach 22 14 43**<br>**80504 München (DE)** |

(54) **Lens assembly for electron beam column**

(57)     A lens assembly for use with an electron beam optical system operating in a vacuum. The lens assembly includes a housing forming a sealed enclosure and at least one lens disposed within the housing. The housing includes a port for connection to a vacuum source for creating a vacuum in the sealed enclosure. A method of creating a vacuum within the lens assembly is also disclosed.

FIGURE 1

**Description**

FIELD OF THE INVENTION

The present invention relates to focused electron beam systems and more particularly to a lens assembly for use in the system.

BACKGROUND OF THE INVENTION

Focused electron beam systems are used in a number of applications including the process of manufacturing integrated circuits. In electron beam lithography, for example, high resolution patterns are created on resist coated wafers or other substrates by a focused electron beam. An electron beam is focused by magnetic lenses, electrostatic lenses, or both. An electron beam is deflected by magnetic deflectors, electrostatic deflectors, or both. Further, the electron beam is enclosed in a vacuum environment to prevent gas molecules from perturbing the electron beam. Focused electron beams are also used in inspection systems for wafers or other substrates, as well as in scanning electron microscopy.

In electron beam lithography, the electron beam focused at the wafer may be a gaussian beam, or it may be shaped like a simple geometric form such as a rectangle or triangle, or as an element of a repetitive pattern to be printed on the substrate. Another class of electron beam lithography systems, electron beam projection systems (EBPS), projects a pattern from a mask onto the substrate. The mask is located in a separate part of the electron beam column and is enclosed in vacuum.

Typically, magnetic lenses and deflectors are employed for the final focusing of the beam on either the mask or substrate because their aberration properties are generally superior to those of electrostatic lenses and deflectors. The magnetic lenses and deflectors are often required to have insulated wiring and auxiliary cooling. Consequently, the lenses and deflectors must be located outside the vacuum of the column in a housing maintained at atmospheric pressure. This facilitates the cooling and prevents outgassing from the insulation or coolant system components from contaminating the electron beam environment. The lenses and deflectors are typically positioned surrounding a cylindrical shaped central beam tube which is sealed at its ends and maintained under vacuum, so the electron beam is unperturbed. Thus, the housing walls and the beam tube must be sized to withstand a pressure differential of at least one atmosphere of pressure. In order to support this pressure differential, the walls of the housing, including an end plate located at an end of the housing adjacent to the substrate, must be relatively thick. As the thickness of the end plate increases, the focal length of the lens must increase as well. Increasing the focal length, however, is undesirable. What is needed, as discussed below, is a reduction in focal length.

Reducing the focal length stems from the need to have higher resolution in electron beam lithography. Higher resolution in an electron beam system generally requires reducing the geometric aberrations of the lenses and deflectors. One technique for reducing the aberrations associated with a lens is to reduce, not increase, the focal length of the lens. A reduction in focal length, however, traditionally requires a reduction in the working distance which is defined as the distance between the focal plane at the target (substrate or mask) and the bottom of the lens (end plate of the housing for a magnetic lens). It is undesirable to reduce the working distance because the working distance must be large enough to provide adequate room for the target, stage, metrology, and related systems. Furthermore, larger working distances can simplify or improve the performance of target stages and metrology systems.

Therefore, what is needed is a magnetic lens assembly which provides a reduced focal length without decreasing the working distance.

SUMMARY OF THE INVENTION

The present invention overcomes the deficiencies of the prior art by providing a magnetic lens, deflector assembly, or combination thereof, which provides a reduced focal length without decreasing the working distance.

Alternatively, a magnetic lens, deflector assembly, or combination thereof, is provided having an increased working distance without increasing the focal length.

A lens assembly of the present invention is for use with an electron beam optical system operating in a vacuum. The lens assembly comprises a housing forming a sealed enclosure and at least one magnetic lens disposed within the housing. The housing is configured for receiving and retaining a vacuum and has a port for connection to a vacuum source for creating a vacuum within the sealed enclosure.

In another aspect of the invention, an electron beam system comprises an electron beam column configured for operation within a vacuum environment (i.e. vacuum chamber). The column has at least one lens assembly positioned generally concentric with a central longitudinal axis of the electron beam column. The lens assembly comprises a housing forming an enclosure sealed off from the electron beam's vacuum chamber. A port is formed in the housing for connection to a vacuum source for creating a vacuum within the sealed enclosure. The housing has an opening extending axially therethrough to provide a path for an electron beam along the axis of the column.

In one embodiment, the vacuum source is in fluid communication with both the lens assembly housing and the vacuum chamber. A pressure regulator, pressure gauge, and one or more shut-off valves may also be inserted into the system to control the application of vacuum to the lens assembly and vacuum chamber.

A method of creating a vacuum within the lens assembly generally comprises:

providing a vacuum source; providing a path for fluid communication between the vacuum source and the vacuum chamber, and the vacuum source and the lens assembly; and creating a vacuum within the lens assembly and vacuum chamber. The vacuum within the lens assembly may be approximately 5% to 10% of atmospheric pressure, for example.

The above is a brief description of some deficiencies in the prior art and advantages of the present invention. Other features, advantages, and embodiments of the invention will be apparent to those skilled in the art from the following description, drawings, and claims.

BRIEF DESCRIPTION OF THE DRAWINGS

Fig. 1 is a schematic of an electron beam column of the present invention;
Fig. 2 is a schematic of a lens assembly for use in the electron beam column of Fig. 1;
Fig. 2A depicts an embodiment of the invention that includes a container for cooling the lens coils and deflectors;
Fig. 3 is a perspective of a modified embodiment of the lens assembly of Fig. 2; and
Fig. 4 is a schematic of a portion of an electron beam system of the present invention.

Corresponding reference characters indicate corresponding parts throughout the several views of the drawings.

DESCRIPTION OF THE INVENTION

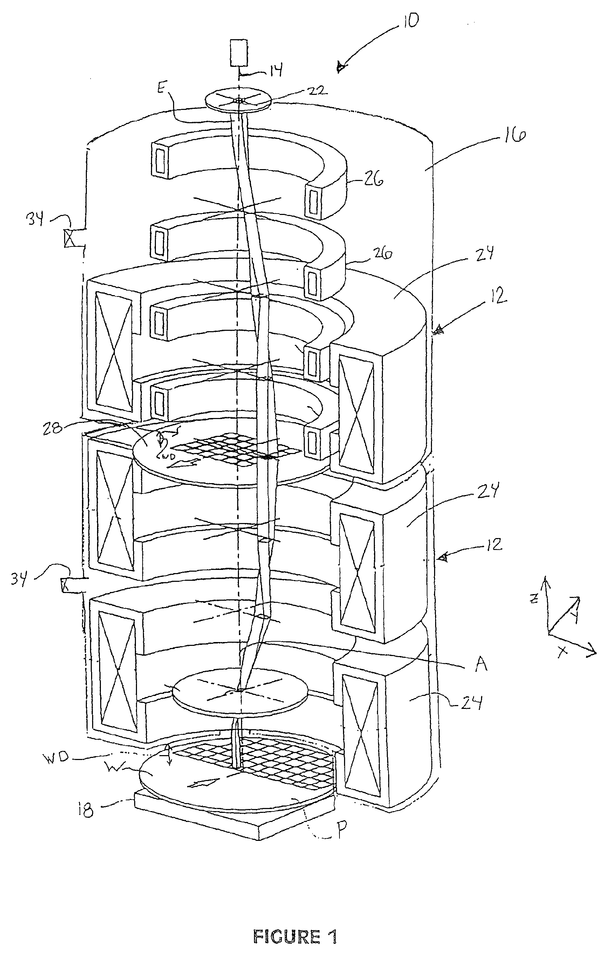

Referring now to the drawings, and first to Fig. 1, a portion of an electron beam projection system (EBPS), generally indicated at 10, is shown having a lens assembly, generally indicated at 12. The electron beam optical system 10 includes an electron beam source 14, an electron beam column 16, and a stage 18 moveable in a number of degrees of freedom for positioning a workpiece such as a semiconductor wafer W relative to the electron beam column to provide accurate alignment of the wafer with the optical system for processing. The electron beam column 16 generally consists of a vertical arrangement of components including condenser lenses, alignment elements, a collination lens, a projection lens, and a deflector system, for example.

In the EBPS 10, a pattern on a reticle 28 is reduced in size and transferred to the wafer. The reticle 28 may also be mounted on a mechanical stage (not shown). The electron beam system 10 operates under vacuum conditions to prevent gas molecules from perturbing the electron beam E. The electron beam source (gun) 14 emits a diverging beam of electrons which is projected onto an illuminating aperture 22 by focusing elements, not shown, creating a collinated beam. The electron beam column 16 includes magnetic lenses 24 operable to focus the beam E onto a surface of the wafer W and deflectors 26 for directing the beam to specific positions on the wafer where photoresist placed on an upper surface of the wafer is to be exposed.

As shown schematically in the electron beam projection system of Fig. 1, the lens assemblies 12 are aligned along the central longitudinal axis A of the electron beam column 16. For clarity, parts of the system are removed to show detail. A reticle (mask) 28 having a circuit pattern formed therein is placed between the lens assemblies 12. The reticle 28 represents a pattern on a layer of an integrated circuit. The electron beam E will step in sequence through portions of the reticle 28, the totality of which represents the pattern of the integrated circuit. As the beam E passes through the reticle 28, the beam is patterned with the information contained in the reticle. The reticle 28 may be mounted on a stage which moves in synchrony with the wafer stage 18 and the deflectors 26, so that the entire pattern on the reticle 28 is reproduced on the wafer.

It is to be understood that the electron beam system may be different than the one shown herein without departing from the scope of the invention. The general reference to the electron beam projection system 10 shown in Fig. 1 is purely for illustrating an embodiment of an environment in which the concept of the lens assembly of the present invention may be advantageously adopted. Further details of the components of an electron beam projection system may be referenced from U.S. Patent Nos. 4,859,856; 5,466,904; and 5,545,902 as well as those described by Petric et al in J. Vac. Sci. Technology B11, 2309 (1993), all of which are hereby incorporated by reference.

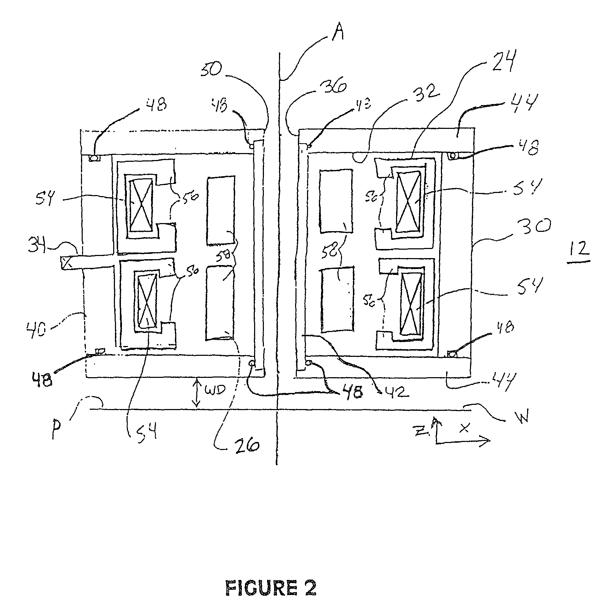

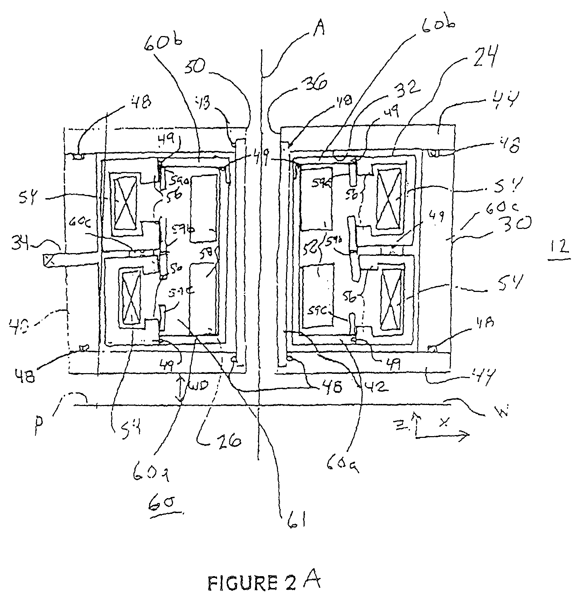

A working distance WD between the lens assembly 12 and the wafer W is defined as the distance between a focal plane P at the target (e.g., semiconductor wafer) and the bottom of the lens assembly 12 (Figs. 1 and 2). A working distance WD between the reticle and the lens assembly is defined as the distance between the top of the reticle 28 and the bottom of the lens assembly 12 located above the reticle, or a distance between the bottom of the reticle and the top of the lens assembly located below the reticle. The working distance WD is preferably as small as possible to reduce the focal length of the lens assembly 12 and thus reduce geometric aberrations. However, the working distance WD should be sufficiently large to provide adequate room for the target (wafer or reticle), stage, and related systems.

The lens assembly 12 includes a housing 30 forming a sealed enclosure 32 configured for receiving and retaining a vacuum (Fig. 2). The housing 30 includes a port 34 for connection to a vacuum source for creating a vacuum in the sealed enclosure 32. The housing 30 is generally cylindrical in shape and has an opening 36 extending axially therethrough to provide a path for the electron beam E along the axis A of the electron beam column 16. A hollow cylindrical inner wall (or beam tube) 42 extends through the axial opening 36 in the housing 30 for passage of the electron beam E and for providing a vacuum column for the beam. The hollow cylinder inner wall (beam tube) 42 is further described in U.S. Patent No. 4,701,623 which is hereby incorporated by reference. In addition to providing a vacuum around the beam, the inner wall 42 satisfies several other requirements. The beam tube must have a high enough electrical resistance to prevent the creation of eddy currents generated by the rapidly changing fields of the magnetic deflectors, which could perturb the beam. However, the electrical resistance should not be so high that the electrons scattered from the beam collect on its inner surface, raising its electrical potential and perturbing the beam. It is typically constructed from glass or ceramic and then coated on its interior surface with a very thin metallic film.

Also, the housing 30 includes a cylindrical outer wall 40, a cylindrical inner wall 42 generally concentric with the outer wall, and two end plates 44 connected to opposite sides of the inner and outer walls. Sealing means 48 are located between the end plates 44 and each of the walls 40, 42. The sealing means 48 comprises an o-ring or any other suitable device sufficient for retaining a vacuum within the housing 30. Each plate 44 has an opening 50 formed therein to provide the electron beam path extending axially through the housing 30. The end plate is preferably formed from a plastic or ceramic material to prevent eddy currents from interfering with the deflectors 26 to provide fast deflection of the electron beam. The port 34 is preferably formed in the outer wall 40 of the housing 30 and may include a quick release for easy attachment of a hose from the vacuum source to the housing.

In a conventional electron beam system, the interior of the housing is typically at atmospheric pressure and the exterior of the housing except for the outer wall 40 is at vacuum. Thus, the walls and end plates of the housing must be sized to withstand atmospheric pressure. The housing 30 of the present invention is configured for receiving and retaining a vacuum pressure equal or close to equal to the operating vacuum of the election beam system 10. This allows the inner wall 42 and end plates 44 of the housing 30 to be sized thinner since they do not have to withstand a significant differential pressure as do conventional lens assembly housings. By reducing the thickness of the end plate 44, the working distance WD is increased without increasing the focal length of the lens assembly 12. Alternatively, for a fixed working distance WD, the lens focal length may be decreased.

For example, in an electron beam projection system as shown in Fig. 1, where the pattern on a reticle 28 is imaged onto the final focal plane, the gap where the reticle is inserted into the electron optical system has a lens assembly above and below it. Therefore, both of the end plates 44 should be reduced in thickness. The end plates 44 are preferably sized to withstand a pressure differential across the plate of no more than about 5-10% of atmospheric pressure or approximately 0.75 to 1.5 psi. By reducing the wall thickness of the cylindrical inner wall 42, more room is made available for the deflection coils. The coils may be positioned closer to the electron beam, increasing the deflection sensitivity.

The thickness of the end plate 44 may also be determined from the expression for the critical pressure at which the plate would fail. This pressure, $P_{crit}$, for a flat circular plate, is given by the expression

$$P_{crit} = \frac{4\sigma_y t^2}{3R^2}$$

where $\sigma_y$ is the fiber stress at yield point of the plate material, t is the end plate thickness, and R is the radius of the plate (Herbert Anderson, *A Physicist's Desk Reference,* American Institute of Physics, 1989). The end plate 44 is actually an annular plate, but the functional relationship is the same. The plate thickness would typically be chosen to give a value of $P_{crit}$ which is some specified multiple of 1 atmosphere, the maximum anticipated load. Thus, if the actual maximum pressure is reduced to say 0.1 atmosphere, the plate thickness could be reduced by a factor of $10^{1/2}=3.16$. If the end plate thickness were initially 6 mm, e.g., the present invention would allow this value to be reduced to approximately 2.0 mm, permitting an increase in the working distance of 4.0 mm, or a corresponding reduction to the lens focal length.

Similarly, for the case of the cylindrical inner wall (beam tube), the critical collapse pressure for a long thin tube with open ends is given by

$$P_{crit} = \frac{1}{4}\frac{E}{1-\eta^2}\frac{t^3}{R^3},$$

where E is Young's modulus of the beam tube material, $\eta$ is Poisson's ratio, t is the wall thickness, and R is the tube radius (R. Roark and W. Young, *Formulas for Stress and Strain,* 6th ed., McGraw-Hill). In this case, using the same argument as before, the wall thickness could, in principle, be reduced by a factor of $10^{1/3}=2.15$.

While the above analysis does not take into consideration the residual strength of the end plate or beam tube when the electron beam column is exactly balanced with the pressure of the lens housing, these residual forces are expected to be far smaller than those associated with the unbalanced 1 atmosphere of pressure experienced in the prior art.

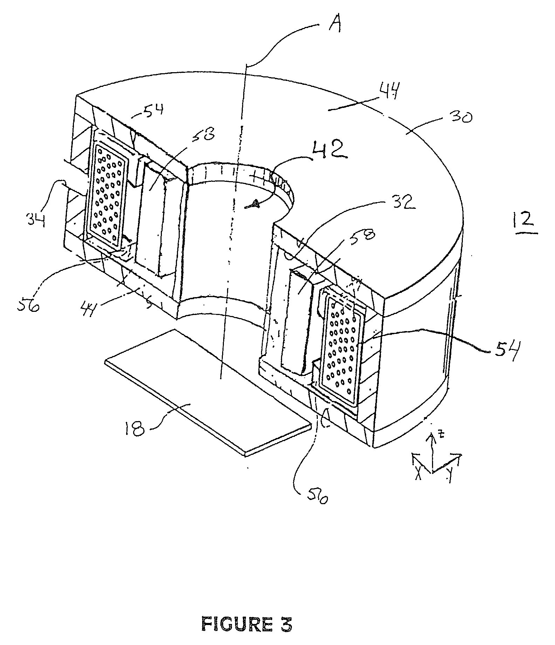

Referring to the embodiment shown in Fig. 1, the lens assembly 12 includes at least one projection lens 24 for focusing the deflected beam E onto the wafer W. The lens assembly 12 may include one lens (as shown in Fig. 3), two lenses (as shown in Figs. 1 and 2), or any other number or arrangement of lenses. The lens 24 includes an excitation coil 54 for applying a magnetic focusing field through pole pieces 56 (Figs. 2 and 3). The magnetic field produces a lens effect similar to physical lenses used in light optics.

The lens assembly 12 further includes a deflector system comprising one or more deflection yokes 26 (Fig. 1). Not all yokes are shown in Fig. 1. The deflection yoke 26 includes one or more magnetic coils 58 which operate to generate a magnetic field in an x-y plane, perpendicular to axis A to deflect the electron beam in both the x and y directions (Figs. 2 and 3). The coils 58 may also deflect the electron beam E orthogonally to the z-axis in the x and y directions. The deflection yoke 26 may be a toroidal shaped magnet having a core and coils wound on the core and distributed to produce the desired radial field for deflection of the beam E in the x and y directions. In operation, the deflection yokes 26 are driven by a controller (not shown) to steer the beam E to selected points on the wafer W or through selected areas in the reticle 28 (Fig. 1). The lens assembly 12 may comprise a variable axis lens to provide high resolution electronic scanning of the wafer W.

The design of the deflection yoke 26, the projection lens 24, and other components of the lens assembly 12 should be made with consideration to proper operation within a vacuum system. Each component should be made from a material whose properties are unaffected by operation in the vacuum. However, since the vacuum within the lens assembly 12 can be relatively poor, a level of outgassing from the components can exist for beyond that tolerable within the e-beam vacuum envelope. Additionally, it should be kept in mind that the sealing of the lens assembly 12 can be less than that tolerable in the electron beam vacuum chamber.

Various methods of cooling the lenses may be employed. In the prior art, the lenses may be cooled using the ambient air. Alternatively, the lenses may be cooled by flowing air or a coolant through the lens assembly enclosure. In the present invention, the lens coils and the deflectors (if they require cooling) must be enclosed in containers which are connected by hoses to a coolant source to prevent coolant from degrading the vacuum. The containers and hoses must be of sufficient strength to withstand at least 1 atmosphere of pressure difference between their interior and exterior. It is to be understood that the deflection yoke, projections lens, and the general arrangement of the lens assembly may be different than described herein without departing from the scope of the invention.

Typically, only the electrical lens coils are cooled, either by sealing them in a can and flowing coolant through it, or by winding the electrical coil from a hollow conductor and flowing coolant through its interior. The coolant must be a non-conductor. Some lenses are made partly of ferrite instead of mild steel. The relatively high resistance of the ferrite prevents the generation of eddy currents from rapidly changing signals to the deflectors. Such eddy currents could perturb the electron beam. Additional ferrite may be used as shielding for the same purpose. Because the magnetic properties of ferrite change significantly with temperature, stable electron optical operation will often require cooling of the ferrite as well. Fig. 2A shows an embodiment of this invention which includes a container for cooling the lens coil, ferrite components of the lens, and the deflector. The ferrite components are shown as several annular cylinders 59a, 59b, and 59c. The lens coils 54, ferrite components 59a, 59b, and 59c, and the deflectors 58 are enclosed in a container 60, comprised of a lower container 60a and a top plate 60b, and, in this design, a spacer 60c between the lenses. The container 60 is made of a nonconducting material such as ceramic or plastic. The container is sealed to the lenses 24 by sealing means 49 which prevents leakage of the coolant 61 which flows inside the container 60. Sealing means 49 may be an o-ring made of material which does not react with the coolant 61. In this design the lenses 24, ferrite 59a, 59b, 59c, container part 60c, and deflectors 58 are assumed to be assembled into a single structure. The details of the internal supports are not shown. Neither are the details of the attachment of this structure to the lens housing outer wall 40. This structure is then installed into the lower container 60a, and the top plate 60b is attached. Not shown in the drawing, coolant is supplied to and recovered from the container 60 by means of tubing which runs from an external supply to conduits in the outer wall 40, through the outer wall 40 conduits to tubing which run to conduits into the container 60. Other designs of course are possible.

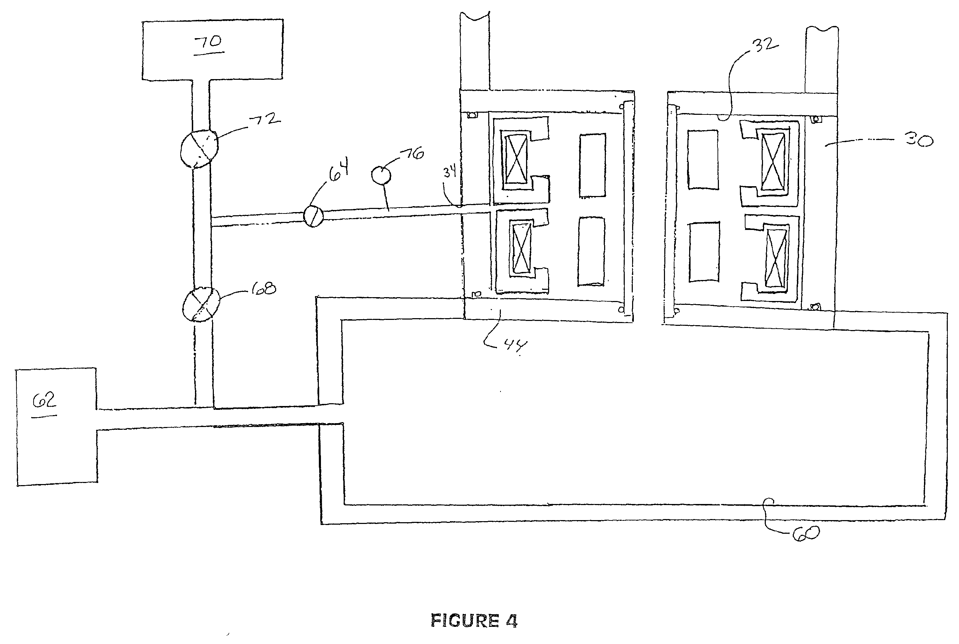

As previously discussed, the end plates 44 and cylindrical inner wall (beam tube) 42 are sized to be relatively thin. Thus care must be taken in creating a vacuum in the lens assembly to prevent distortion and possible damage to the plates. Further, if a single vacuum source is provided to create a vacuum within the lens assembly 12 and electron beam vacuum chamber, care should be taken to prevent contaminants disposed within the interior of the housing 30 from migrating into other parts of the system such as the electron beam column where they could impair normal operation. One possible arrangement of a system for applying a vacuum to the lens assembly 12 and vacuum chamber of the electron beam system 10 is shown in Fig. 4. The vacuum source 62 is a pump or other suitable device and is connected to the lens assembly 12 and a vacuum chamber 60 attached to the electron beam column 16 so that the vacuum source is in fluid communication with both the sealed enclosure 32 and the vacuum chamber 60. A pressure regulator 64 (e.g., restrictor) is located proximate to the port 34 to adjust the vacuum level within the sealed enclosure 32 and limit the level of the vacuum to prevent damage to the housing since the volume of the sealed enclosure is much smaller than the volume of the vacuum chamber 60. A first shut-off valve 68 is located within the path between the vacuum source 62 and the lens assembly housing 30 downstream of the flow regulator 64. (Downstream is defined as a location near the vacuum source since the flow is into the vacuum source).

A second pump (roughing pump) 70 is connected to the path between the vacuum source 62 and the sealed enclosure 32 at a location between the first shut-off valve 68 and the pressure regulator 64 to prevent contamination of the vacuum chamber 60 as described below. A second shut-off valve 72 is located between the second pump 70 and the regulator 64 and the first shut-off valve 68. A gauge 76 may be installed near the lens assembly housing 30 to monitor the vacuum level within the housing. A gauge may also be installed to measure the vacuum within the vacuum chamber 60 or any other part of the system.

In operation, the vacuum source 62 and the second pump 70 are connected to the lens assembly housing 30 and vacuum chamber 60 as shown in Fig. 4 with both the first and second shut-off valves in a closed position and the vacuum source 62 turned off. The first shut-off valve 68 is opened and a vacuum is applied to the vacuum chamber 60 and housing 30 until the pressure is about 5% to 10% of atmospheric pressure (i.e., .735 psi - 1.47 psi). The flow regulator 64 is adjusted as required to prevent a large pressure differential from forming across the end plate 44 of the housing. When the predetermined vacuum condition is reached in the housing 30, the first shut-off valve 68 is closed and the second shut-off valve 72 is opened. Prior to closing the first shut-off valve 68 the flow to the vacuum source 62 is in a viscous flow regime and backflow of any contaminants from the interior of the housing 30 to the vacuum chamber 60 is prevented. It is to be understood that the system and method used to create a vacuum in the lens assembly housing 30 may be different than described herein without departing from the scope of the invention. For example, separate vacuum sources and systems may be used for the lens assembly 12 and electron beam column 16.

It will be observed from the foregoing that the lens assembly of the present invention has numerous advantages. Importantly, one or both of the end plates of the housing may be reduced in thickness, thus providing an increased working distance without increasing the focal length of the lens. Additionally, the wall thickness of the cylindrical inner wall may be reduced to provide an increase in deflection sensitivity.

In view of the above, it will be seen that the several objects of the invention are achieved and other advantageous results attained. As various changes could be made in the above constructions and methods without departing from the scope of the invention, it is intended that all matter contained in the above description and shown in the accompanying drawings shall be interpreted as illustrative and not in a limiting sense.

## Claims

1. A lens assembly for use with an electron beam optical system operating in a vacuum, the lens assembly comprising a housing forming a sealed enclosure and at least one lens disposed within the housing, the housing being configured for receiving and retaining a vacuum and having a port for connection to a vacuum source for creating a vacuum within the sealed enclosure.

2. The lens assembly of claim 1 wherein the housing is generally cylindrical in shape and comprises at least one end plate having an opening extending therethrough to provide an electron beam path, the end plate being sized to withstand a pressure differential across the end plate of no more than 1.5 psi.

3. The lens assembly of claim 1 wherein the housing comprises a cylindrical outer wall, a cylindrical inner wall generally concentric with the outer wall, two end plates connected to opposite ends of the inner and outer walls, each plate having an opening formed therein to provide an electron beam path extending axially through the housing, and at least one seal located between each of the end plates and the inner and outer walls.

4. The lens assembly of claim 3 wherein the seal comprises an o-ring.

5. The lens assembly of claim 3 wherein the port extends from the exterior of the housing through the outer wall and into said sealed enclosure.

6. The lens assembly of claim 1 further comprising a gauge in fluid communication with said sealed enclosure for monitoring the vacuum within the said sealed enclosure.

7. The lens assembly of claim 1 further comprising a container for cooling the at least one lens.

8. The lens assembly of claim 1 further comprising at least one deflector disposed within the housing for deflecting an electron beam.

9. The lens assembly of claim 8 further comprising a container for cooling the at least one lens and the at least one deflector.

**10.** The lens assembly of claim 1 wherein said at least one lens comprises two magnetic projection lenses.

**11.** The lens assembly of claim 10 wherein each of the magnetic lenses comprises a field generating coil and at least two pole pieces.

**12.** An electron beam system comprising an electron beam column configured for operation within a vacuum chamber, the column having at least one lens assembly positioned generally concentric with a central longitudinal axis of the electron beam column, the lens assembly comprising a housing forming an enclosure sealed off from said vacuum chamber and having a port for connection to a vacuum source for creating a vacuum within said sealed enclosure, the housing having an opening extending axially therethrough to provide a path for an electron beam along the central axis of the column.

**13.** The electron beam system of claim 12 further comprising an electron beam gun located at one end of the electron beam column and a stage for supporting a workpiece located at an opposite end of the column, the stage being movable relative to the column to position the workpiece.

**14.** The electron beam system of claim 12 wherein the vacuum source is in fluid communication with the vacuum chamber to create a vacuum therein.

**15.** The electron beam system of claim 12 further comprising a pressure regulator for regulating the vacuum within said sealed enclosure.

**16.** The electron beam system of claim 12 further comprising a first shut-off valve located between the vacuum source and the housing.

**17.** The electron beam system of claim 16 further comprising a pump in fluid communication with the sealed enclosure and a second shut-off valve located between the housing and the pump.

**18.** The electron beam system of claim 12 wherein the lens assembly further comprises a deflector disposed within the housing.

**19.** The electron beam system of claim 12 wherein the lens assembly further comprises a magnetic projection lens having a coil and at least two pole pieces.

**20.** The electron beam system of claim 12 further comprising a container for cooling the lens assembly.

**21.** A method of creating a vacuum within a lens assembly for use with an electron beam optical system operating in a vacuum chamber, the lens assembly comprising a housing defining a sealed enclosure and a port for connection to a vacuum source for creating a vacuum in said sealed enclosure, the method comprising:

providing a path for fluid communication between the vacuum source and the vacuum chamber and the vacuum source and the lens assembly; and
creating a vacuum within the lens assembly and the vacuum chamber .

**22.** The method of claim 21 further comprising inserting a flow regulator in the path between the vacuum source and lens assembly.

**23.** The method of claim 22 further comprising inserting a first shut-off valve in the path between the vacuum source and the lens assembly downstream of the flow regulator.

**24.** The method of claim 23 wherein creating a vacuum comprises:

opening the first shut-off valve;
creating a vacuum within the lens assembly of approximately 5% to 10% of atmospheric pressure;
adjusting the flow regulator as required;
closing the first shut-off valve upon creating the vacuum within the lens assembly.

**25.** The method of claim 24 further comprising:

providing a pump;
creating a path from the pump to the flow regulator and the first shut-off valve;
inserting a second shut-off valve in the path between the pump and the flow regulator and the first shut-off valve;
closing the second shut-off valve prior to opening the first shut-off valve; and
opening the second shut-off valve after closing the first shut-off valve.

FIGURE 1

FIGURE 2

FIGURE 2 A

FIGURE 3

FIGURE 4

**EP 1 239 509 A1**

## EUROPEAN SEARCH REPORT

**European Patent Office**

Application Number

EP 02 00 4970

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 013, no. 235 (E-766), 30 May 1989 (1989-05-30) & JP 01 041155 A (MITSUBISHI ELECTRIC CORP), 13 February 1989 (1989-02-13) * abstract * | 1,3-5,7, 11,12, 20,21 | H01J37/141 H01J37/18 H01J37/301 |
| A | US 5 412 211 A (KNOWLES W RALPH) 2 May 1995 (1995-05-02) * column 14, line 63 – column 15, line 65; figures 3,14,15 * | 1,12,21 | |
| A | US 5 250 808 A (DANILATOS GERASIMOS D ET AL) 5 October 1993 (1993-10-05) * column 4, line 44 – column 6, line 54; figure 2 * | 1,12,21 | |
| A | PATENT ABSTRACTS OF JAPAN vol. 1999, no. 09, 30 July 1999 (1999-07-30) & JP 11 111205 A (HITACHI LTD;HITACHI SCI SYST LTD), 23 April 1999 (1999-04-23) * abstract * | 1,12,21 | TECHNICAL FIELDS SEARCHED (Int.Cl.7) H01J |

The present search report has been drawn up for all claims

| Place of search | Date of completion of the search | Examiner |
|---|---|---|
| THE HAGUE | 15 July 2002 | Schaub, G |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

13

**ANNEX TO THE EUROPEAN SEARCH REPORT
ON EUROPEAN PATENT APPLICATION NO.**                    EP 02 00 4970

This annex lists the patent family members relating to the patent documents cited in the above-mentioned European search report.
The members are as contained in the European Patent Office EDP file on
The European Patent Office is in no way liable for these particulars which are merely given for the purpose of information.

15-07-2002

| Patent document cited in search report | | Publication date | Patent family member(s) | | Publication date |
|---|---|---|---|---|---|
| JP 01041155 | A | 13-02-1989 | NONE | | |
| US 5412211 | A | 02-05-1995 | US | 5362964 A | 08-11-1994 |
| | | | AT | 189558 T | 15-02-2000 |
| | | | DE | 69422932 D1 | 09-03-2000 |
| | | | DE | 69422932 T2 | 05-10-2000 |
| | | | EP | 0753200 A1 | 15-01-1997 |
| | | | EP | 0924743 A1 | 23-06-1999 |
| | | | JP | 9501010 T | 28-01-1997 |
| | | | WO | 9504367 A1 | 09-02-1995 |
| US 5250808 | A | 05-10-1993 | US | 4785182 A | 15-11-1988 |
| | | | US | 4823006 A | 18-04-1989 |
| | | | AT | 86409 T | 15-03-1993 |
| | | | AU | 603226 B2 | 08-11-1990 |
| | | | AU | 1790088 A | 21-12-1988 |
| | | | CA | 1293337 A1 | 17-12-1991 |
| | | | CN | 1031154 A ,B | 15-02-1989 |
| | | | DE | 3878828 D1 | 08-04-1993 |
| | | | DE | 3878828 T2 | 09-06-1993 |
| | | | EP | 0314763 A1 | 10-05-1989 |
| | | | EP | 0330310 A2 | 30-08-1989 |
| | | | ES | 2007856 A6 | 01-07-1989 |
| | | | IL | 86430 A | 16-02-1992 |
| | | | JP | 1502225 T | 03-08-1989 |
| | | | JP | 5032860 B | 18-05-1993 |
| | | | KR | 9705031 B1 | 11-04-1997 |
| | | | MX | 174400 B | 13-05-1994 |
| | | | RU | 2020643 C1 | 30-09-1994 |
| | | | WO | 8809564 A1 | 01-12-1988 |
| | | | US | 4897545 A | 30-01-1990 |
| | | | US | 4880976 A | 14-11-1989 |
| | | | ZA | 8803273 A | 11-11-1988 |
| | | | AT | 89951 T | 15-06-1993 |
| | | | AU | 2834589 A | 24-08-1989 |
| | | | CA | 1310141 A1 | 10-11-1992 |
| | | | CN | 1039324 A ,B | 31-01-1990 |
| | | | DE | 68906686 D1 | 01-07-1993 |
| | | | DE | 68906686 T2 | 16-09-1993 |
| | | | ES | 2040992 T3 | 01-11-1993 |
| | | | JP | 1309243 A | 13-12-1989 |
| | | | JP | 2674603 B2 | 12-11-1997 |
| | | | KR | 172938 B1 | 01-02-1999 |
| | | | RU | 2039394 C1 | 09-07-1995 |
| JP 11111205 | A | 23-04-1999 | NONE | | |

EPO FORM P0459